# EUROPÄISCHE PATENTANMELDUNG

(11) **EP 3 706 018 A1**
(43) Veröffentlichungstag der Anmeldung: **09.09.2020**
(21) Anmeldenummer: 19161326.4
(22) Anmeldetag: 07.03.2019
(51) Int. Cl.: G06F 17/50, G06Q 50/00

(54) **ANORDNUNG UND VERFAHREN ZUR KONFIGURATION EINES TECHNISCHEN SYSTEMS**

(71) Anmelder: Siemens Aktiengesellschaft, 80333 München (DE)
(72) Erfinder: Fries, Edgar, 91077 Neunkirchen am Brand (DE)

(57) **Zusammenfassung**

Die vorliegende Erfindung schafft eine optimierte und automatisierte Konzeption von individuell zu planenden technischen Anlagen. Hierzu werden zunächst bei bereits bestehenden technischen Anlagen Betriebsparameter erfasst und zentral gespeichert. Soll eine neue technische Anlage geplant werden, so können die Spezifikationen für die neue Anlage mit den zuvor erfassten Betriebsparametern abgeglichen werden, um auf effiziente Weise eine optimale Konfiguration der neuen technischen Anlage zu generieren.

## Beschreibung

Die vorliegende Erfindung betrifft eine Anordnung und ein Verfahren zur Konfiguration eines technischen Systems. Die vorliegende Erfindung betrifft insbesondere die Konfiguration bzw. die Auslegung eines individuell zu konzipierenden technischen Systems.

### Stand der Technik

Mit steigender Komplexität von technischen Systemen, wie zum Beispiel komplexen Anlagen, steigen auch die Anforderungen für die Auslegung und Entwicklung derartiger komplexer technischer Systeme. Hierbei ist eine zunehmende Anzahl von Rahmenbedingungen, insbesondere von technischen Parametern, zu berücksichtigen. Solche Parameter sind zum Beispiel Umgebungstemperaturen, Vibrationen, Störgrößen benachbarter Systeme, denen das technische System ausgesetzt ist, oder auch ein Alterungsverhalten bzw. Ausfallraten von verwendeten Komponenten. Diese und weitere Parameter haben einen erheblichen Einfluss auf die Auslegung eines neu zu konzipierenden technischen Systems. Um Störungen oder gar einen vorzeitigen Ausfall eines technischen Systems zu vermeiden, müssen die verwendeten Betriebsmittel ausreichend groß dimensioniert und ausgelegt werden. Um Störungen oder einen vorzeitigen Ausfall eines technischen Systems vorzubeugen, werden die verwendeten Betriebsmittel in der Regel eher großzügig dimensioniert. Dies ist jedoch mit zusätzlichen Kosten und gegebenenfalls auch zusätzlichem erforderlichen Bauraum verbunden. Andererseits würde eine zu geringe Dimensionierung der verwendeten Betriebsmittel vermehrt zu Störungen und gegebenenfalls einem Stillstand des technischen Systems führen.

Es ist daher wünschenswert, möglichst präzise Informationen über ein zu erwartendes Betriebsverhalten eines technischen Systems, sowie der eingesetzten Betriebsmittel zu erhalten. Weiterhin ist es wünschenswert, ein neu zu konzipierendes technisches System möglichst optimal, das heißt weder übernoch unterdimensioniert zu konzipieren.

Vor diesem Hintergrund ist es eine Aufgabe der vorliegenden Erfindung, eine Anordnung und ein Verfahren zur Konfiguration eines technischen Systems zu schaffen, welches eine möglichst optimale Konfiguration eines neu zu konzipierenden technischen Systems ermöglicht.

### Offenbarung der Erfindung

Die vorliegende Erfindung schafft hierzu eine Anordnung und ein Verfahren zur Konfiguration eines technischen Systems mit den Merkmalen der unabhängigen Patentansprüche. Weitere vorteilhafte Ausführungsformen sind Gegenstand der abhängigen Patentansprüche.

Gemäß einem ersten Aspekt ist eine Anordnung zur Konfiguration eines technischen Systems vorgesehen. Die Anordnung umfasst eine Anzahl von mindestens einem, vorzugsweise mehrerer Erfassungseinrichtungen, eine Speichereinrichtung und eine Konfigurationseinrichtung. Die Erfassungseinrichtungen sind dazu ausgelegt, jeweils vorbestimmte Betriebsparameter eines bestehenden technischen Systems zu erfassen. Die Speichereinrichtung ist dazu ausgelegt, die von der Anzahl von Erfassungseinrichtungen erfassten Betriebsparameter zu empfangen und zu speichern. Die Konfigurationseinrichtung ist dazu ausgelegt, vorgegebene Spezifikationen für ein neu zu konzipierendes technisches System zu empfangen. Die Konfigurationseinrichtung ist weiter dazu ausgelegt, die in der Speichereinrichtung gespeicherten Betriebsparameter auszulesen. Ferner ist die Konfigurationseinrichtung dazu ausgelegt, unter Verwendung der vorgegebenen Spezifikationen und der gespeicherten Betriebsparameter eine Konfiguration für das neu zu konzipierende technische System zu ermitteln.

Gemäß einem weiteren Aspekt ist ein Verfahren zur Konfiguration eines technischen Systems vorgesehen. Das Verfahren umfasst einen Schritt zum Erfassen vorbestimmter Betriebsparameter einer Anzahl von einem oder mehreren bestehenden technischen Systemen. Weiterhin umfasst das Verfahren einen Schritt zum Speichern der erfassten Betriebsparameter in einer zentralen Speichereinrichtung. Das Verfahren umfasst ferner einen Schritt zum Empfangen vorgegebener Spezifikationen für ein neu zu konzipierendes technisches System, zum Auslesen der in der Speichereinrichtung gespeicherten Betriebsparameter und zum Ermitteln einer Konfiguration für das neu zu konzipierende technische System. Das Ermitteln der Konfiguration für das neu zu konzipierende technische System erfolgt insbesondere unter Verwendung der vorgegebenen Spezifikationen und der gespeicherten Betriebsparameter.

Der vorliegenden Erfindung liegt die Erkenntnis zugrunde, dass bei der Planung und Dimensionierung von technischen Systemen, insbesondere bei der Planung und Dimensionierung von technischen Anlagen, die Konfiguration und die Auswahl der erforderlichen Betriebsparameter eine entscheidende Rolle spielen. Insbesondere führt eine Konfiguration mit übermäßigen Sicherheitszuschlägen zu erhöhtem Aufwand und damit verbunden zu einem größeren erforderlichen Bauraum sowie zu steigenden Kosten. Andererseits kann eine Unterdimensionierung von verwendeten Betriebsmitteln zu einem vorzeitigen Ausfall oder Beschädigungen der zu konzipierenden Anlage führen. Darüber hinaus liegt der vorliegenden Erfindung die Erkenntnis zugrunde, dass gerade bei individuell zu konzipierenden technischen Systemen bzw. Anlagen sehr oft nur geringe Kenntnisse über das Betriebsverhalten der jeweiligen technischen Systeme bzw. Anlagen zur Verfügung steht. Hierdurch ist es nicht oder zumindest nur sehr schwer möglich, ein neu zu konzipierendes technisches System optimal zu konfigurieren. Es ist daher eine Idee der vorliegenden Erfindung, dieser Erkenntnis Rechnung zu tragen und die Konfiguration eines technischen Systems zur Planung und Dimensionierung zu verbessern. Hierzu ist es vorgesehen, das Betriebsverhalten von bereits bestehenden technischen Systemen automatisiert zu erfassen, zu speichern und auszuwerten. Auf diese Weise kann eine Datenbasis gewonnen werden, welche für eine Konzeption eines neuen technischen Systems ausgewertet und berücksichtigt werden kann. Durch einen Zugriff auf eine solche stetig wachsende Datenbasis ist es somit möglich, ein neu zu konzipierendes technisches System möglichst optimal zu konfigurieren. Auf diese Weise können sowohl Überdimensionierung von Betriebsmitteln, als auch Unterdimensionierungen und somit vorzeitige Fehler oder Ausfälle vermieden werden. Hierdurch ist es möglich, einen zuverlässigen Betrieb des neu zu konzipierenden technischen Systems zu gewährleisten und dabei auf übermäßige Sicherheitszuschläge zu verzichten.

Die zu ermittelnde Konfiguration des neu zu konzipierenden technischen Systems kann beispielsweise eine Auswahl oder zumindest einen Vorschlag für eine Auswahl eines Betriebsmittels aus mehreren zur Verfügung stehenden Betriebsmitteln umfassen. Auf diese Weise kann für jeden individuellen Anwendungsfall eines neu zu konzipierenden technischen Systems jeweils ein optimal geeignetes Betriebsmittel identifiziert werden. Darüber hinaus kann die Konfiguration beispielsweise auch eine Auslegung einer entsprechenden Temperierung, beispielsweise Heizung oder Kühlung für Betriebsmittel umfassen. Beispielsweise kann auf Grundlage der Daten von bereits bestehenden technischen Systemen eine Prognose für das Betriebsverhalten des neu zu konzipierenden technischen Systems erstellt werden. Basierend auf dieser Prognose kann daraufhin eine Konfiguration, insbesondere eine Dimensionierung von Betriebsmitteln oder ähnlichem festgelegt werden. Eine solche Dimensionierung kann beispielsweise auch das Ermitteln einer geeigneten Anzahl von parallel zu schaltenden Betriebsmitteln umfassen. Auf diese Weise kann eine Überlastung einzelner Betriebsmittel vermieden werden. Andererseits kann auf eine übermäßige Redundanz verzichtet werden. Es versteht sich jedoch, dass die Datenbasis des Betriebsverhaltens von bereits bestehenden technischen Systemen auch für beliebige andere Parameter zur Konfiguration eines neu zu konzipierenden technischen Systems angewendet werden kann.

Die Erfassungseinrichtung kann insbesondere zu jeder beliebigen und geeigneten Art der Erfassung von Betriebsparametern bestehender technischer Systeme ausgelegt sein. Beispielsweise kann die Erfassungseinrichtung kontinuierlich vorbestimmte Betriebsparameter, wie zum Beispiel eine Betriebstemperatur oder im Nachfolgenden noch näher erläuterte andere Betriebsparameter, erfassen. Gegebenenfalls können die Betriebsparameter auch nur nach Über- oder Unterschreiten von vorgegebenen Grenzwerten erfasst werden. Darüber hinaus ist auch das Erfassen der Betriebsparameter in Folge eines beliebigen anderen Triggerereignisses möglich. Die jeweiligen Betriebsparameter können dabei beispielsweise mit einer vorgegebenen zeitlichen Erfassungsrate und/oder einer vorgegebenen Genauigkeit erfasst werden. Die Abtastrate bzw. Genauigkeit kann gegebenenfalls angepasst werden. Die Betriebsparameter können neben physikalischen Eigenschaften, wie Temperatur, Druck, Feuchtigkeit, Durchflussrate, Leistung, Spannung, Stromstärke, etc., die beispielsweise mittels geeigneter Sensoren erfasst werden, auch beliebige andere Parameter, wie beispielsweise Regelgrößen, insbesondere Sollwerte oder ähnliches, umfassen. Darüber hinaus können beispielsweise auch Eingriffe eines Benutzers, beispielsweise zum Einstellen eines bestimmten Betriebszustandes oder ähnlichem als Betriebsparameter erfasst werden.

Die erfassten Betriebsparameter können beispielsweise direkt zu einer externen Speichereinrichtung übertragen werden. Alternativ ist auch zunächst eine Vorverarbeitung der erfassten Betriebsparameter in der Erfassungseinrichtung möglich. Auf diese Weise können beispielsweise irrelevante Daten gefiltert bzw. eliminiert werden, oder es kann eine beliebige andere Vorverarbeitung der erfassten Betriebsparameter erfolgen.

Bei der Speichereinrichtung kann es sich um eine beliebige geeignete Speichereinrichtung zur Speicherung der Betriebsparameter von einem oder mehreren technischen Systemen handeln. Beispielsweise können die Betriebsparameter zu der Speichereinrichtung mittels einer geeigneten Kommunikationsschnittstelle, beispielsweise mittels eines Datennetzwerkes über eine kabelgebundene und/oder kabellose Funkverbindung übertragen werden.

Die Speichereinrichtung kann die empfangenden Betriebsparameter zunächst aufbereiten bzw. vorverarbeiten. Weiterhin kann die Speichervorrichtung die empfangenen Betriebsparameter speichern und für die Auswertung durch die Konfigurationseinrichtung bereitstellen. Beispielsweise kann es sich bei der Speichervorrichtung um einen zentralen Speicher in einer Cloud oder ähnlichem handeln. Darüber hinaus kann es auch vorgesehen sein, dass die Speichereinrichtung in einem besonders geschützten Bereich vorgesehen ist, um beispielsweise die gespeicherten Betriebsparameter vor unzulässigem Zugriff zu schützen.

Gemäß einer Ausführungsform umfassen die von den Erfassungseinrichtungen erfassten Betriebsparameter eine minimale und/oder maximale Betriebstemperatur eines Betriebsmittels, ein Über- und/oder Unterschreiten eines Schwellwerts, einen Ausfall eines Betriebsmittel, insbesondere einen Zeitpunkt des Ausfalls des Betriebsmittels sowie gegebenenfalls weitere mit dem Ausfall verbundene Daten, eine Einschalt- und/oder Ausschaltzeitdauer eines Betriebsmittels, eine relative Belastung eines Betriebsmittels und/oder einen Nutzungsgrad eines Betriebsmittels. Darüber hinaus können selbstverständlich auch beliebige andere Betriebsparameter der bestehenden technischen Systeme erfasst werden. Wie zuvor bereits angeführt, können neben den physikalischen Eigenschaften, insbesondere sensorisch erfassten physikalischen Parameter auch Regelgrößen, insbesondere Sollwertvorgaben oder Benutzereingaben erfasst werden. Darüber hinaus ist selbstverständlich die Erfassung beliebiger anderer Betriebsparameter der bestehenden technischen Systeme möglich.

Gemäß einer Ausführungsform ist die Konfigurationseinrichtung dazu ausgelegt, eine Dimensionierung einer Baugruppe eines neu zu konzipierenden technischen Systems unter Verwendung einer maximalen Beanspruchung einer korrespondierenden Baugruppe eines bestehenden technischen Systems festzulegen. Die maximale Beanspruchung der korrespondierenden Baugruppe des bestehenden technischen Systems kann insbesondere unter Verwendung der gespeicherten Betriebsparameter ermittelt werden. Beispielsweise kann die Konfigurationseinrichtung die gespeicherten Betriebsparameter analysieren, um die in den korrespondierenden technischen Systemen aufgetretene maximale Beanspruchung zu ermitteln. Diese maximale Beanspruchung kann beispielsweise als Grundlage für die Dimensionierung einer Baugruppe in einem neu zu konzipierenden technischen System herangezogen werden. Bei einer maximalen Beanspruchung kann es sich beispielsweise um eine maximal auftretende Temperatur, eine maximale Leistung, einen maximalen Durchfluss, oder aber auch um Durchschnittswerte oder ähnliches handeln. Durch die Berücksichtigung der tatsächlichen Betriebswerte von bereits bestehenden technischen Systemen kann die Auslegung des neu zu konzipierenden technischen Systems optimal an die zu erwartenden Betriebsverhältnisse angepasst werden.

In einer Ausführungsform ist die Konfigurationseinrichtung dazu ausgelegt, eine zu erwartende Beanspruchung einer Baugruppe des neu zu konzipierenden technischen Systems unter Verwendung der in der Speichereinrichtung gespeicherten Betriebsparameter zu bestimmen. Bei der zu erwartenden Beanspruchung kann es sich beispielsweise um eine zu erwartende Durchschnitts- oder Maximaltemperatur, eine Durchschnitts- oder Maximalleistung, Durchflussmenge oder beliebige andere Größe handeln. Darüber hinaus sind gegebenenfalls auch zu erwartende Sollwertvorgaben, Einschaltdauern oder ähnliches möglich. Die zu erwartende Beanspruchung kann beispielsweise durch Analyse der gespeicherten Betriebsparameter der bereits bestehenden technischen Systeme abgeschätzt werden. Beispielsweise können korrespondierende Betriebsparameter der bereits bestehenden technischen Systeme identifiziert werden. Diese können zum Beispiel entsprechend skaliert, interpoliert oder anderweitig abgeschätzt werden, um eine entsprechende zu erwartende Beanspruchung des neu zu konzipierenden technischen Systems zu bestimmen.

Gemäß einer Ausführungsform ist die Konfigurationseinrichtung dazu ausgelegt, die Erfassung der vorbestimmten Betriebsparameter der bestehenden technischen Systeme anzupassen. Beispielsweise kann die Erfassungsrate oder die Genauigkeit der zu erfassenden Betriebsparameter durch die Erfassungseinrichtung entsprechend modifiziert werden. Hierzu kann die Konfigurationseinrichtung mit den Erfassungseinrichtungen über eine entsprechende Kommunikationsverbindung gekoppelt werden. Auf diese Weise kann die Konfigurationseinrichtung auch zu jedem späteren Zeitpunkt die Erfassung der Betriebsparameter in den bestehenden technischen Systemen anpassen bzw. steuern. Auf diese Weise kann beispielsweise eine Erfassung von Betriebsparametern gestoppt werden, wenn derartige Betriebsparameter gegebenenfalls nicht weiter von Interesse sind. Ebenso ist es auch möglich, gegebenenfalls zu einem späteren Zeitpunkt die Erfassung von bestimmten Betriebsparametern zu initiieren. Ferner ist es auch möglich, eine bestehende Erfassung von Betriebsparametern zu modifizieren, um beispielsweise die Genauigkeit der Erfassung anzupassen, gegebenenfalls Triggerereignisse einzustellen oder anzupassen, die die Erfassung von Betriebsparametern steuern oder beliebige weitere Parameter für die Erfassung der Betriebsparameter anzupassen.

Gemäß einer Ausführungsform ist die Konfigurationseinrichtung dazu ausgelegt, die Erfassung der vorbestimmten Betriebsparameter in den bestehenden technischen Systemen unter Verwendung der vorgegebenen Spezifikationen für ein neu zu konzipierendes technisches System anzupassen. Beispielsweise kann mittels der Konfigurationseinrichtung festgestellt werden, dass für die Konfiguration des neu zu konzipierenden technischen Systems eine präzise bzw. präzisere Kenntnis eines oder mehrerer Betriebsparameter erforderlich ist. In diesem Fall kann die Genauigkeit für die Erfassung des entsprechenden Betriebsparameters durch die Erfassungseinrichtungen angepasst werden. Ferner kann in der Konfigurationseinrichtung beispielsweise festgestellt werden, dass ein oder mehrere zusätzliche Betriebsparameter von Interesse sind, um eine geeignete Konfiguration des neu zu konzipierenden technischen Systems zu erstellen. In diesem Fall kann durch die Konfigurationseinrichtung die Erfassung der gewünschten zusätzlichen Betriebsparameter durch die Erfassungseinrichtungen initiiert werden. Darüber hinaus ist selbstverständlich auch jede beliebige andere Modifikation der Erfassung der Betriebsparameter in den bestehenden technischen Systemen möglich, insbesondere eine Erfassung von Betriebsparametern in den technischen Systemen, die durch die Spezifikationen für das neu zu konzipierende technische System getriggert ist.

Gemäß einer Ausführungsform umfasst die Anzahl der Erfassungseinrichtungen jeweils einen Speicher und eine Verarbeitungseinrichtung. Der Speicher ist dazu ausgelegt, die erfassten Betriebsparameter zu speichern. Insbesondere kann der Speicher der Erfassungseinrichtung die Funktion eines Zwischenspeichers haben. Die Verarbeitungseinrichtung ist dazu ausgelegt, die in dem Speicher gespeicherten Betriebsparameter zu komprimieren. Ferner ist die Verarbeitungseinrichtung dazu ausgelegt, die komprimierten Betriebsparameter an die Speichereinrichtung zu übertragen. Das Komprimieren der Betriebsparameter kann insbesondere eine beliebige geeignete Verarbeitung der Betriebsparameter umfassen. Beispielsweise kann das Komprimieren eine Filterung der erfassten Betriebsparameter umfassen, um gegebenenfalls nicht oder weniger relevante Betriebsparameter zu eliminieren. Ferner kann das Komprimieren auch ein Zusammenfassen mehrerer gleicher oder gleichartiger Werte umfassen. Darüber hinaus kann das Komprimieren gegebenenfalls auch ein Anpassen der erfassten Werte auf ein alternatives Zeitraster und/oder eine alternative Abtastgenauigkeit umfassen. Selbstverständlich sind darüber hinaus auch beliebige andere Verfahren zur Verarbeitung der erfassten Betriebsparameter, insbesondere zur Minimierung des Datenvolumens der erfassten Betriebsparameter möglich.

Das Übertragen der Betriebsparameter von der Verarbeitungseinrichtung zur Speichereinrichtung kann auf eine beliebige geeignete Weise erfolgen. Beispielsweise kann das Übertragen mittels einer kabelgebundenen Kommunikationsverbindung erfolgen. Darüber hinaus ist ebenso eine kabellose Kommunikationsverbindung, beispielsweise eine Funkverbindung basierend auf einem geeigneten Kommunikationsstandard, beispielsweise GSM, UMTS, LTE, 5G oder ähnliches möglich.

Gemäß einer Ausführungsform ist die Erfassungseinrichtung dazu ausgelegt, die vorbestimmten Betriebsparameter kontinuierlich oder in vorbestimmten Zeitintervallen an die Speichereinrichtung zu übertragen. Auf diese Weise ist eine stetige Überwachung der Betriebsparameter der bereits bestehenden technischen Systeme möglich. Die Betriebsparameter können beispielsweise in Echtzeit an die Speichereinrichtung übertragen werden. Ferner ist es auch möglich, die Betriebsparameter zunächst in einem Speicher der Erfassungseinrichtung zwischenzuspeichern und jeweils gebündelt zu vorbestimmten Zeitpunkten an die Speichereinrichtung zu übertragen. Auf diese Weise kann in der Speichereinrichtung ein nahezu kontinuierlicher Verlauf der Entwicklung der überwachten Betriebsparameter vorgehalten werden.

In einer alternativen Ausführungsform ist die Erfassungseinrichtung dazu ausgelegt, die vorbestimmten Betriebsparameter zu übertragen, wenn ein vorbestimmtes Ereignis in dem jeweiligen bestehenden technischen System detektiert worden ist. Beispielsweise kann beim Eintreffen eines vorgegebenen Triggerereignisses eine Übertragung der Betriebsparameter von der Erfassungseinrichtung zu der Speichereinrichtung ausgeführt werden. Ein solches Triggerereignis kann beispielsweise ein Über- oder Unterschreiten eines Schwellwerts, ein Ausfall eines Betriebsmittels oder ein beliebiges anderes Ereignis sein. Auf diese Weise kann die Menge der anfallenden Daten, insbesondere die Menge, der zu übertragenden und in der Speichereinrichtung zu speichernden Daten minimiert werden.

Gemäß einer Ausführungsform umfasst die Speichereinrichtung eine Klassifizierungseinrichtung. Die Klassifizierungseinrichtung kann dazu ausgelegt sein, die von der Erfassungseinrichtung bereitgestellten Daten basierend auf vorbestimmten Kriterien zu klassifizieren und/oder zu gruppieren. Auf diese Weise kann in der Speichereinrichtung eine Vorverarbeitung der empfangenen Betriebsparameter erfolgen. Insbesondere kann die Speichereinrichtung die empfangenen Betriebsparameter in einer strukturierten Form entsprechend der Klassifizierung abspeichern. Auf diese Weise kann die Speichereinrichtung die gespeicherten Daten entsprechend der Klassifizierung strukturiert und effizient für die Weiterverarbeitung bereitstellen.

Gemäß einer Ausführungsform umfassen die vorbestimmten Kriterien für die Klassifizierung eine räumliche Position des jeweiligen bestehenden technischen Systems, eine Häufigkeit von Fehlern, eine Fehlerursache, eine Auslastung des jeweiligen bestehenden technischen Systems und/oder einen Betriebszustand des jeweiligen bestehenden technischen Systems. Darüber hinaus sind selbstverständlich auch beliebige andere Kriterien zur Klassifizierung der erfassten Betriebsparameter möglich.

Gemäß einer Ausführungsform umfasst die Konfigurationseinrichtung ein neuronales Netz. Das neuronale Netz kann insbesondere dazu ausgelegt sein, die Konfiguration des neu zu konzipierenden technischen Systems zu ermitteln. In diesem Fall kann die Konfigurationseinrichtung dazu ausgelegt sein, das neuronale Netz unter Verwendung der in der Speichereinrichtung gespeicherten Betriebsparameter zu trainieren. Das Training des neuronalen Netzwerkes kann beispielsweise basierend auf einem manuellen Ereignis initiiert werden. Alternativ ist auch ein automatisches Trainieren des neuronalen Netzes aufgrund von vorbestimmten Ereignissen in einem oder mehreren bestehenden Systemen oder aufgrund der Detektion eines bestimmten Ereignisses in den von dem bestehenden technischen System bereitgestellten Betriebsparametern möglich. Darüber hinaus kann das neuronale Netz beispielsweise auch regelmäßig in vorgegebenen Zeitintervallen automatisch trainiert werden. Auf diese Weise ist eine effiziente Erstellung der Konfigurationsparameter für ein neu zu konzipierendes technisches System möglich.

Gemäß einer Ausführungsform umfasst das Ermitteln der Konfiguration des neu zu konzipierenden technischen Systems eine Berechnung einer Ausfallwahrscheinlichkeit für ein vorbestimmtes Betriebsmittels des neu zu konzipierenden technischen Systems. Die Ausfallwahrscheinlichkeit kann unter Verwendung der gespeicherten Betriebsparameter berechnet werden. Insbesondere kann auf Grundlage der berechneten Ausfallwahrscheinlichkeit eine Dimensionierung eines Betriebsmittels in dem neu zu konzipierenden technischen System ermittelt werden. Die Dimensionierung kann insbesondere auch die Auslegung einer Redundanz eines Betriebsmittels umfassen.

Die obigen Ausgestaltungen und Weiterbildungen lassen sich, soweit sinnvoll, beliebig miteinander kombinieren. Weitere Ausgestaltungen, Weiterbildungen und Implementierungen der Erfindung umfassen auch nicht explizit genannte Kombinationen von zuvor oder im Folgenden bezüglich den Ausführungsbeispielen beschriebenen Merkmalen der Erfindung. Insbesondere wird der Fachmann dabei auch Einzelaspekte als Verbesserungen oder Ergänzungen zu den jeweiligen Grundformen der vorliegenden Erfindung hinzufügen.

### Kurze Beschreibung der Zeichnungen

Die vorliegende Erfindung wird nachfolgend anhand der in den schematischen Figuren der Zeichnungen angegebenen Ausführungsbeispiele näher erläutert. Dabei zeigen:
- Fig. 1: eine schematische Darstellung eines Blockschaubilds einer Anordnung zur Konfiguration eines technischen Systems gemäß einem Ausführungsbeispiel;
- Fig. 2: eine schematische Darstellung eines Blockschaubilds einer Anordnung zur Konfiguration eines technischen Systems gemäß einem weiteren Ausführungsbeispiel;
- Fig. 3: eine schematische Darstellung eines Blockschaubilds einer Anordnung zur Konfiguration eines technischen Systems gemäß noch einem weiteren Ausführungsbeispiel; und
- Fig. 4: eine schematische Darstellung eines Ablaufdiagramms, wie es einem Verfahren zur Konfiguration eines technischen Systems gemäß einer Ausführungsform zugrunde liegt.

### Ausführungsformen der Erfindung

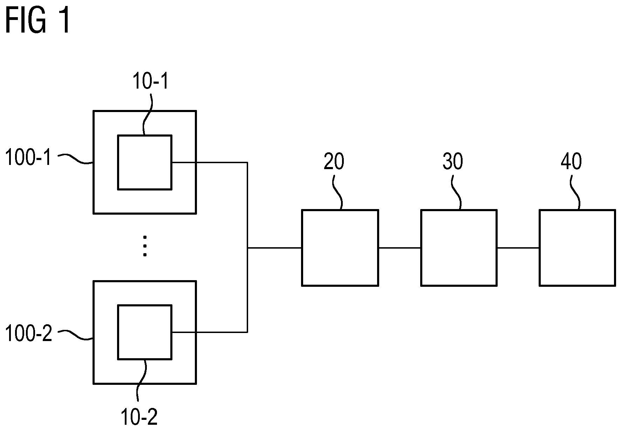

Fig. 1 zeigt eine schematische Darstellung eines Blockschaubilds einer Anordnung zur Konfiguration eines technischen Systems gemäß einer Ausführungsform. Die Anordnung umfasst in diesem Beispiel mehrere Erfassungseinrichtungen 10-i, eine Speichereinrichtung 20 und eine Konfigurationseinrichtung 30. Jede der Erfassungseinrichtungen 10-i kann beispielsweise in einem bestehenden technischen System 100-i vorgesehen sein. Die hier dargestellte Anzahl von lediglich zwei technischen Systemen 100-i mit jeweils einer Erfassungseinrichtung 10-i dient nur dem Verständnis. Darüber hinaus ist auch jede beliebige anderen Anzahl von technischen Systemen 100-i mit Erfassungseinrichtungen 10-i möglich. Insbesondere kann eine beliebige größere Anzahl von technischen Systemen 100-i jeweils mit einer Erfassungseinrichtung 10-i überwacht werden. Darüber hinaus können auch weitere Daten von Erfassungseinrichtungen 10-i bereitgestellt werden, welche nicht unmittelbar in oder an einem bestehenden technischen System 100-i vorgesehen sind. Beispielsweise können zusätzlich auch Daten von externen Erfassungseinrichtungen beispielsweise einer Wetterstation oder ähnlichem bereitgestellt werden. Diese Weise können auch Informationen über externe Einflüsse erfasst werden, welche sich auf den Betrieb eines bestehenden technischen Systems 100-i auswirken.

Bei den bestehenden technischen Systemen 100-i kann es sich um beliebige technische Systeme, insbesondere beliebige technische Anlagen handeln. Beispielsweise kann es sich bei den technischen Systemen 100-i um Kraftwerke zur Erzeugung elektrischer Energie, Umspannanlagen, Stromrichter, beispielsweise Wechselrichter zur Umwandlung von Gleichspannung in eine ein- oder mehrphasige Wechselspannung, technische Anlagen zur Herstellung bestimmter Produkte, beispielsweise Fertigungsanlagen der Papierindustrie, Produktionsanlagen für beliebige andere Produkte, Anlagen der chemischen Industrie, oder beliebige andere technische Anlagen handeln. Es versteht sich, dass die Anwendung zur Konzeption technischer Systeme nicht auf die zuvor beschriebenen Einzelfälle beschränkt ist. Vielmehr können beliebige technische Systeme bzw. Anlagen entsprechend konzipiert und konfiguriert werden.

Während des Betriebs der bestehenden technischen Systeme 100-i können zahlreiche Betriebsparameter der jeweiligen technischen Systeme 100-i erfasst werden. Hierzu können beispielsweise Sensoren vorgesehen sein, die einen oder mehrere physikalische Parameter innerhalb des jeweiligen technischen Systems 100-i erfassen. Darüber hinaus können auch Steuerbefehle zwischen einzelnen Komponenten des jeweiligen technischen Systems 100-i protokolliert werden. Derartige Steuerbefehle können zwischen einzelnen Komponenten des jeweiligen technischen Systems 100-i ausgetauscht werden. Ferner können auch Steuerbefehle oder Sollwertvorgaben von einer zentralen Leitstelle an Komponenten des technischen Systems 100-i ausgegeben werden. Grundsätzlich können auch beliebige weitere Betriebsparameter des technischen Systems 100-i erfasst und an der jeweiligen Erfassungseinrichtung 10-i bereitgestellt werden. Die Betriebsparameter können direkt als digitale Daten an der jeweiligen Erfassungseinrichtung 10-i bereitgestellt werden. Alternativ können auch analoge Signale an der Erfassungseinrichtung 10-i bereitgestellt werden, und die analogen Signale können mittels eines geeigneten Analog-Digitalwandlers (nicht dargestellt) in digitale Signale konvertiert werden. Die weitere Verarbeitung der erfassten Betriebsparameter in der Erfassungseinrichtung 10-i wird weiter unten noch näher erläutert.

Die erfassten Betriebsparameter können von den Erfassungseinrichtungen 10-i der jeweiligen technischen Systeme 100-i an eine zentrale Speichereinrichtung 20 übertragen werden. Beispielsweise können die Erfassungseinrichtungen 10-i mit der Speichereinrichtung 20 über eine geeignete Kommunikationsverbindung, beispielsweise eine kabelgebundene oder kabellose Verbindung, verbunden werden. Beispielsweise kann die Übertragung über eine Internetverbindung, insbesondere über eine geschützte Internetverbindung wie zum Beispiel einen VPN Tunnel oder ähnliches übertragen werden. Die Übertragung kann darüber hinaus zumindest teilweise auch über eine kabellose Verbindung, insbesondere eine Funkverbindung, wie zum Beispiel eine Mobilfunkverbindung, erfolgen.

Die Speichereinrichtung 20 kann die jeweiligen Betriebsparameter von den Erfassungseinrichtungen 10-i empfangen und speichern. Gegebenenfalls kann vor dem Speichern der Betriebsparameter zunächst eine Vorverarbeitung der empfangenen Betriebsparameter, beispielsweise eine Kategorisierung, Klassifizierung oder ähnliches erfolgen. Dies wird im Nachfolgenden noch näher erläutert.

Für die Konzeption eines neuen technischen Systems kann die in der Speichereinrichtung 20 gespeicherte Datenbasis der Betriebsparameter der bestehenden technischen Systeme 100-i herangezogen werden. Insbesondere kann dabei eine zumindest teilweise automatische Ermittlung von Eigenschaften für ein neu zu konzipierendes technisches System unter Verwendung der in der Speichereinrichtung 20 gespeicherten Betriebsparameter erfolgen. Dies wird im Nachfolgenden näher erläutert.

Soll ein neues technisches System konzipiert werden, so können der Konfigurationseinrichtung 30 die erforderlichen Spezifikationen für das neu zu konzipierende technische System bereitgestellt werden. Diese Spezifikationen können beispielsweise gewünschte Eigenschaften des neu zu konzipierenden technischen Systems umfassen. Beispielsweise können die Spezifikationen eine gewünschte (maximale) Leistung des Systems, insbesondere eine elektrische Leistung, ein gewünschter Durchsatz einer bestimmten Stoffmenge, eine Menge eines Ausgangsproduktes, Eigenschaften von Eingangswerten, beispielsweise eine Eingangsspannung, eine maximale Eingangsleistung, Menge oder Eigenschaften von Substanzen, die als Ausgangsprodukte bereitgestellt werden oder ähnlich umfassen. Darüber hinaus sind selbstverständlich auch beliebige andere Spezifikationen möglich. Insbesondere können die Spezifikationen beispielsweise auch Vorgaben für einzusetzende Baugruppen, Bauelemente oder ähnliches umfassen. Weitere Spezifikationen, wie beispielsweise Eigenschaften über einen geplanten Standort und damit verbundene Rahmenbedingungen wie Temperatur, mögliche Kühlleistung etc. können ebenfalls spezifiziert werden.

Die Konfigurationseinrichtung 30 kann daraufhin die spezifizierten Anforderungen für das neu zu konzipierende technische System mit den Daten über die Betriebsparameter der bestehenden technischen Systeme abgleichen, die in der Speichereinrichtung 20 gespeichert sind. Auf diese Weise kann beispielsweise abgeleitet werden, welche bereits in Verwendung befindlichen Komponenten in der Lage sind, die Anforderungen gemäß den Spezifikationen für das neu zu konzipierende technische System zu erfüllen. Beispielsweise kann aus den in der Speichereinrichtung 20 gespeicherten Betriebsparametern festgestellt werden, ob eine gemäß den Spezifikationen des neu zu konzipierenden technischen Systems erforderliche Ausgangsleistung mit einer oder mehreren Baugruppen von bereits bestehenden technischen Systemen erreicht werden kann. Insbesondere können dabei auch weitere Rahmenbedingungen, wie beispielsweise eine auftretende maximale Erwärmung, eine damit verbundene Kühlleistung, etc. berücksichtigt werden. Weiterhin können beispielsweise Häufigkeiten von Fehlfunktionen sowie Ausfälle von Bauelementen in bereits bestehenden technischen Systemen auf Grundlage der in der Speichereinrichtung 20 gespeicherten Betriebsparameter ermittelt werden. Aus diesen Daten kann beispielsweise eine erforderliche Redundanz von Baugruppen abgeleitet werden, die erforderlich ist, um eine gemäß den Spezifikationen für das neu zu konzipierende technische System geforderte Betriebssicherheit zu erzielen. Auf diese Weise kann beispielsweise eine erforderliche Anzahl von Standbykomponenten bestimmt werden, die erforderlich ist, um eventuell ausfallende Baugruppen zu ersetzen, sodass ein gewünschtes Wartungsintervall für den Austausch von fehlerhaften Komponenten eingehalten werden kann. Es versteht sich jedoch, dass die hier angeführten Beispiele zur Konzeption und Konfiguration eines neu zu konzipierenden technischen Systems auf Grundlage der vorgegebenen Spezifikationen und der gespeicherten Betriebsparameter von bereits bestehenden technischen Systemen nur beispielhaft zu verstehen sind. Selbstverständlich können auch beliebige andere Konfigurationen und Dimensionierungen, Auslegungen etc. auf Grundlage von vorgegebenen Spezifikationen für ein neu zu konzipierendes technisches System und Daten über die Betriebsparameter von bereits bestehenden technischen Systemen ermittelt werden.

Die Ermittlung von Vorgaben für die Konfiguration, Auslegung, Dimensionierung von Baugruppen, erforderliche Redundanz etc. des neu zu konzipierenden technischen Systems kann dabei ganz oder zumindest teilweise automatisch durch die Konfigurationseinrichtung 30 erfolgen. Hierzu kann die Konfigurationseinrichtung 30 über eine geeignete Datenschnittstelle die gespeicherten Betriebsparameter aus der Speichereinrichtung 20 auslesen. Ferner können die Informationen über die Spezifikationen des neu zu konzipierenden technischen Systems über geeignete Datenschnittstellen an der Konfigurationseinrichtung 30 bereitgestellt werden. Gegebenenfalls ist auch eine manuelle Eingabeschnittstelle für die Spezifikation von Eigenschaften des neu zu konzipierenden technischen Systems möglich. Die automatisch erstellte Konfiguration des neu zu konzipierenden technischen Systems kann an einer Ausgangsschnittstelle der Konfigurationseinrichtung 30 bereitgestellt werden. Gegebenenfalls können die automatisch erstellten Parameter manuell editiert werden. Darüber hinaus ist auch eine automatische Weiterverarbeitung bis hin zur automatischen Planung und Dimensionierung der Baugruppen des neu zu konzipierenden technischen Systems möglich.

Die durch die Konfigurationseinrichtung 30 generierte Konfiguration für das neu zu konzipierende technische System kann daraufhin als Grundlage für das weitere Engeneering genutzt werden. Insbesondere kann das weitere Engeneering des neu zu konzipierenden technischen Systems ganz oder zumindest teilweise automatisiert erfolgen. Hierzu können die Daten der durch die Konfigurationseinrichtung 30 generierten Konfiguration beispielsweise einer Planungseinrichtung 40 zugeführt werden. Die Planungseinrichtung 40 empfängt die Daten der Konfiguration von der Konfigurationseinrichtung 30 und erstellt erforderliche Planungsunterlagen des neu zu konzipierenden technischen Systems. Beispielsweise können die Planungsunterlagen Schaltpläne, Parameterlisten oder Softwarestrukturen umfassen.

Für die Erstellung der Planungsunterlagen in der Planungseinrichtung 40 können beispielsweise geeignete Vorlagen, sogenannte Templates, bereitgestellt werden. Diese Vorlagen können beispielsweise in einem internen Speicher der Planungseinrichtung 40 oder von einer externen Datenbank bereitgestellt werden. Für die Erstellung einer elektrischen Anlage kann eine solche Vorlage beispielsweise einen Schaltplan oder zumindest eine Grundstruktur eines Schaltplans umfassen. Die Planungseinrichtung 40 kann daraufhin auf Grundlage der von der Konfigurationseinrichtung 30 bereitgestellten Konfiguration geeignete Bauelemente für die einzelnen Komponenten des Schaltplans automatisch ermitteln. Gegebenenfalls können die erforderlichen Bauelemente auf Grundlage der bereitgestellten Konfiguration entsprechend dimensioniert werden. Beispielsweise kann auch eine erforderliche Anzahl redundanter Bauelemente auf Grundlage der bereitgestellten Konfiguration bestimmt werden. Darüber hinaus sind selbstverständlich auch beliebige andere Schritte für die automatische Planung des neu zu konzipierenden technischen Systems möglich.

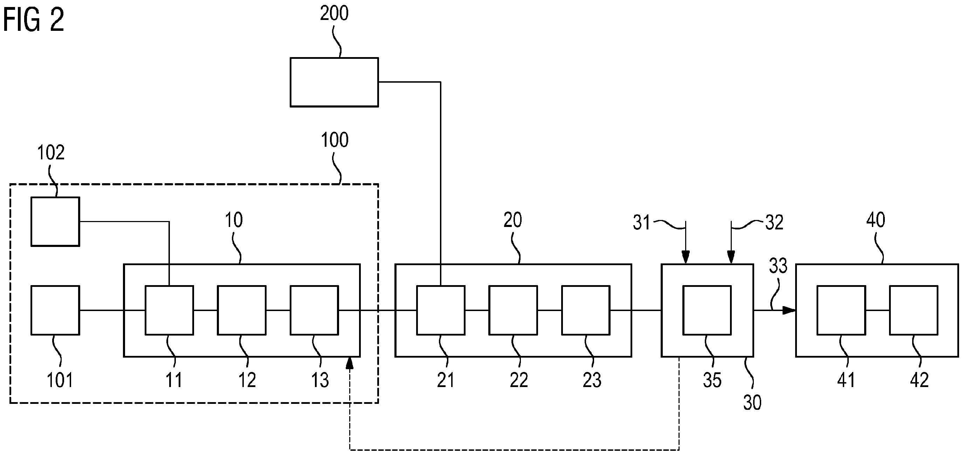

Fig. 2 zeigt eine schematische Darstellung eines Blockschaubilds einer Anordnung zur Konfiguration eines technischen Systems gemäß einer weiteren Ausführungsform. Hierbei gelten auch die bereits zuvor in Zusammenhang mit Fig. 1 gemachten Ausführungen.

Wie in Fig. 2 zu erkennen ist, kann die Erfassungseinrichtung 10 in einem technischen System 100 beispielsweise eine Empfangseinrichtung 11 aufweisen, welche Daten über Betriebsparameter des bestehenden technischen Systems 100 empfängt. Die Empfangseinrichtung 11 kann beispielsweise mit einer Leitstelle oder einer Steuereinrichtung 101 verbunden sein. In diesem Fall kann die Empfangseinrichtung 11 von der Steuereinrichtung 101 Steuergrößen, insbesondere Sollwertvorgaben oder ähnliches empfangen. Darüber hinaus kann die Empfangseinrichtung 11 mit einem oder mehreren Sensoren 102 gekoppelt sein. Jeder der Sensoren 102 kann einen oder mehrere physikalische Parameter innerhalb des technischen Systems 100 erfassen und ein zu der erfassten Größe korrespondierendes analoges oder digitales Signal bereitstellen. Wird das Signal in analoger Form bereitgestellt, so kann die Empfangseinrichtung 11 beispielsweise einen Analog-Digitalkonverter umfassen, welcher das analoge Signal in digitale Daten konvertiert. Darüber hinaus können auch beliebige andere Betriebsparameter des bestehenden technischen Systems 100 durch die Empfangseinrichtung 11 erfasst werden.

Weiterhin kann die Erfassungseinrichtung 10 eine Verarbeitungseinrichtung 12 umfassen. Die Verarbeitungseinrichtung 12 kann beispielsweise die von der Empfangseinrichtung 11 erfassten Betriebsparameter vor der Übertragung zu der Speichereinrichtung 20 verarbeiten. Beispielsweise können die Daten der empfangenen Betriebsparameter komprimiert werden. Auf diese Weise kann die Datenmenge, welche von der Erfassungseinrichtung 10 zu der Speichereinrichtung 20 übertragen werden soll, minimiert werden. Beispielsweise kann die Komprimierung eine Filterung von irrelevanten und/oder redundanten Daten umfassen. Darüber hinaus kann auch eine beliebige andere zeitliche Komprimierung oder eine Komprimierung der Auflösung der Informationen erfolgen. Ferner ist es beispielsweise möglich, nur Betriebsparameter zu erfassen und/oder zu übertragen, welche mit einem vorbestimmten Triggerereignis korrespondieren. So können beispielsweise nur dann Betriebsparameter erfasst und/oder übertragen werden, wenn ein vorgegebener Schwellwert über- oder unterschritten wird. Darüber hinaus ist auch eine beliebige andere Vorverarbeitung der erfassten Betriebsparameter vor der Übertragung zu der Speichereinrichtung 20 möglich.

Für die Übertragung der Betriebsparameter von der Erfassungseinrichtung 10 zu der Speichereinrichtung 20 kann die Erfassungseinrichtung 10 beispielsweise eine geeignete Schnittstelle 13 aufweisen. Beispielsweise kann es sich bei der Schnittstelle 13 um eine Netzwerkschnittstelle handeln. Die Übertragung von der Erfassungseinrichtung 10, insbesondere der Schnittstelle 13 zu der Speichereinrichtung 20 kann beispielsweise über eine kabelgebundene Verbindung erfolgen. Alternativ kann die Übertragung auch zumindest teilweise über eine kabellose Verbindung, insbesondere eine Mobilfunkverbindung oder ähnliches erfolgen. In diesem Fall kann die Schnittstelle 13 beispielsweise eine entsprechende Funkschnittstelle umfassen.

Die Speichereinrichtung 20 kann eine Empfangsschnittstelle 21 umfassen, welche Daten der Betriebsparameter von den Erfassungseinrichtungen der bestehenden technischen Systeme 100 empfängt. Analog zu der Schnittstelle 13 der Erfassungseinrichtung 10 kann die Empfangsschnittstelle 21 eine kabelgebundene Kommunikationsverbindung oder eine kabellose Funkverbindung realisieren.

Wie zuvor bereits angeführt, können neben den Betriebsparametern aus dem bestehenden technischen System 100, wie den oben angeführten Werten der Steuereinrichtung 101 und den Sensoren 102 auch weitere, insbesondere externe Daten erfasst werden. Diese Daten können beispielsweise von einer externen Datenquelle 200 bereitgestellt werden. Die externe Datenquelle 200 kann über eine kabelgebundene oder kabellose Schnittstelle die entsprechenden Daten an die Speichereinrichtung 20 übertragen.

Bei der externen Datenquelle 200 kann sich um eine beliebige Datenquelle handeln, welche Informationen, insbesondere Informationen im Zusammenhang mit dem Betrieb des bestehenden technischen Systems 100 bereitstellt. Beispielweise kann es sich bei der externen Datenquelle um eine Wetterstation handeln, welche Daten über Temperatur, Luftdruck, Luftfeuchte, Windrichtung oder Windgeschwindigkeit etc. bereitstellt. Weiterhin kann sich bei der externen Datenquelle 200 auch um eine Messstelle eines Gewässers handeln, welche beispielsweise Informationen über eine Pegelhöhe, Wassertemperatur, Fließgeschwindigkeit o. ä. bereitstellt. Selbst verständlich sind je nach Anwendungsfall auch beliebige andere Datenquellen möglich. Beispielsweise können auch von einem externen Rechenzentrum, insbesondere einer Cloud oder ähnlichem, Daten bereitgestellt werden.

Auf diese Weise können beispielsweise bei einem Kraftwerk, wie beispielsweise einem Windkraftwerk oder einem Solarkraftwerk, Informationen über Windgeschwindigkeit, Windrichtung, solare Einstrahlung etc. mitberücksichtigt werden.

Darüber hinaus kann die Speichereinrichtung 20 beispielsweise eine Klassifizierungseinrichtung 22 umfassen. Diese Klassifizierungseinrichtung 22 kann beispielsweise eine (Vor)Verarbeitung der empfangenen Betriebsparameter durchführen. Beispielsweise kann die Klassifizierungseinrichtung 22 die empfangenen Betriebsparameter entsprechend vorbestimmter Eigenschaften gruppieren oder klassifizieren. Die Klassifizierung kann beispielsweise entsprechend den Eigenschaften der Betriebsparameter erfolgen. Beispielsweise können die Betriebsparameter entsprechend einer räumlichen Position des jeweiligen bestehenden technischen Systems 100, einer Häufigkeit von Fehlern in dem bestehenden technischen System, einer Fehlerursache, einer Auslastung des jeweiligen bestehenden technischen Systems oder einem Betriebszustand des jeweiligen technischen Systems klassifiziert werden. Selbstverständlich sind auch beliebige andere Klassifizierungen der empfangenen Betriebsparameter möglich. Beispielsweise kann bei den empfangenen Betriebsparametern auch unterschieden werden, ob die Betriebsparameter zu einem normalen Betriebszustand gehören, oder ob die Betriebsparameter während eines Fehlerfalls erfasst worden sind. Darüber hinaus können auch Betriebsparameter zu bestimmten Betriebszuständen, beispielsweise einem kritischen Betriebszustand, einer Überbelastung des jeweiligen technischen Systems, einem Leerlauf des technischen Systems oder ähnlichem gruppiert werden.

Die empfangenen und gegebenenfalls weiterverarbeiteten Betriebsparameter können daraufhin in einem Speicher 23 der Speichereinrichtung 20 gespeichert werden.

Für die Konzeption eines neuen technischen Systems kann die Konfigurationseinrichtung 30 auf die in dem Speicher 23 der Speichereinrichtung 20 gespeicherten Daten zurückgreifen. Darüber hinaus kann das neu zu konzipierende technische System beispielsweise durch Vorgabe von individuellen Anforderungen 31 für das neu zu konzipierende technische System, sowie technischen Parametern 32 für das zu konzipierende technische System sowie Baugruppen des technischen Systems charakterisiert werden. Die Konfigurationseinrichtung 30 gleicht daraufhin die Anforderungen 31, die technischen Parameter 32 und die erfassten Betriebsparameter von bestehenden technischen Systemen 100 miteinander ab und erstellt daraufhin geeignete Konfigurationsparameter 33 für das neu zu konzipierende technische System. Hierzu kann beispielsweise die Ausfallwahrscheinlichkeit von Komponenten in bestehenden technischen Systemen, Belastungsgrenzen von Baugruppen in bestehenden technischen Systemen, sowie weitere Informationen, die aus den Betriebsparametern abgeleitet werden können, mit den Erfordernissen des neu zu konzipierenden technischen Systems abgeglichen werden, wie dies bereits zuvor beschrieben worden ist.

Beispielsweise kann die Ermittlung der Konfigurationsparameter 33 für das neu zu konzipierende technische System mittels eines neuronalen Netzes 35 erfolgen. Hierbei können beispielsweise die Anforderungen 31 und die technischen Spezifikationen 32 als Eingangsgrößen dem neuronalen Netz 35 bereitgestellt werden. Das neuronale Netz 35 kann dabei beispielsweise mittels der erfassten Betriebsparameter der bestehenden technischen Systeme 100 zuvor trainiert werden.

Darüber hinaus ist es beispielsweise möglich, die Erfassung der Betriebsparameter in den bestehenden technischen Systemen 100 dynamisch anzupassen. Auf diese Weise können auch die Betriebsparameter der bestehenden technischen Systeme 100 in geeigneter Weise erfasst werden, wenn sich die Anforderungen für die Konzeption eines neuen technischen Systems im Laufe der Zeit ändern. Beispielsweise können für die Konzeption von neuen technischen Systemen Anforderungen oder Spezifikationen bestehen, die das Erfassen weiterer Betriebsparameter in bestehenden technischen Systemen 100 erforderlich machen. Analog ist es auch möglich, dass sich im Laufe der Zeit die Erfassung von Betriebsparametern erübrigt, welche ursprünglich erfasst worden sind. Hierzu kann, beispielsweise ausgehend von der Konfigurationseinrichtung 30 die Erfassung der Betriebsparameter in den Erfassungseinrichtungen 10 angepasst werden. Insbesondere kann dabei auch ein Zeitintervall für die Erfassung der Betriebsparameter, eine Genauigkeit für die Erfassung der Betriebsparameter oder ein Triggerereignis für die Erfassung der Betriebsparameter angepasst werden.

Die von der Konfigurationseinrichtungen 30 generierten Konfigurationsparameter 33 können einer Planungseinrichten 40 zur Erzeugung der erforderlichen Engineering-Unterlagen weitergeleitet werden. Die Planungseinrichtung 40 kann beispielsweise eine erste Einrichtung 41 zur Erzeugung einer Systemarchitektur und eine zweite Einrichtung 42 zur Erzeugung der erforderlichen Engineering-Unterlagen auf Grundlage der Systemarchitektur umfassen. Das Erstellen der Systemarchitektur und/oder der Engineering-Unterlagen kann hierbei ganz oder zumindest teilweise automatisch auf Grundlage der bereitgestellten Konfigurationsparameter 33 erfolgen.

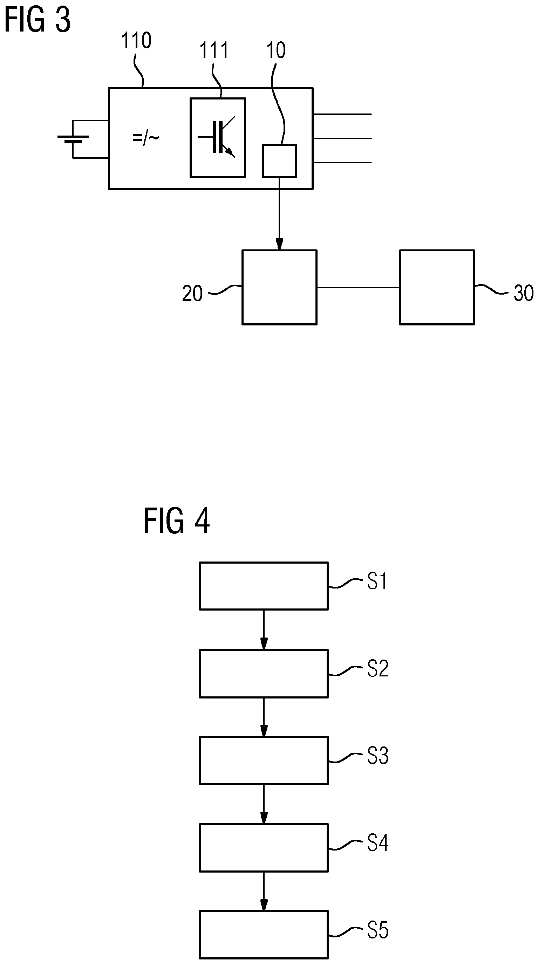

Fig. 3 zeigt eine schematische Darstellung eines konkreten Ausführungsbeispiels für die Konfiguration eines technischen Systems, am Beispiel eines Spannungswandlers 110. Wie in Fig. 3 zu erkennen ist, wird an dem Spannungswandler 110 eine Gleichspannung bereitgestellt, welche durch den Spannungswandler 110 in eine dreiphasige Wechselspannung überführt werden soll. Hierzu sind in dem Spannungswandler 110 mehrere Halbleiterschaltelemente 111 vorgesehen. Diese Halbleiterschaltelemente 111 besitzen jedoch nur eine begrenzte Lebensdauer. Entsprechend muss erwartet werden, dass im Laufe des Betriebs des Spannungswandlers 110 nach und nach zumindest einige der Halbleiterschaltelemente 111 einen Defekt aufweisen werden. Daher ist in dem Spannungswandler 110 eine gewisse Anzahl von redundanten Halbleiterschaltelementen 111 vorgesehen. Diese können beim Defekt eines Halbleiterschaltelementes 111 die Funktion des defekten Halbleiterschaltelementes 111 übernehmen. Defekte Halbleiterschaltelemente 111 werden dabei während eines turnusmäßigen Wartungsintervalls durch neue Halbleiterschaltelemente ersetzt. Daher ist in dem Spannungswandler 110 eine ausreichend große Anzahl von redundanten Halbleiterschaltelementen 111 vorzusehen, sodass der sichere Betrieb zwischen zwei planmäßigen Wartungen gewährleistet werden kann. Für die Konzeption eines neuen Spannungswandlers muss deshalb eine geeignete Anzahl von redundanten Schaltelementen ermittelt werden. Hierzu kann der Betrieb von bestehenden Spannungswandlern 110 überwacht und protokolliert werden. Die dabei erfassten Betriebsdaten können für eine optimale Konfiguration eines neu zu entwickelnden Spannungswandlers herangezogen werden.

Daher ist in bestehenden Spannungswandlern 110 jeweils eine Erfassungseinrichtung 10 vorgesehen, welche die Funktion der Schaltelemente 111 überwacht. Weiterhin können das Auftreten einer Fehlfunktion in einem Schaltelement 111 und die damit verbundenen Rahmenbedingungen erfasst und protokolliert werden. Die auf diese Weise erfassten Informationen können in der Speichereinrichtung 20 bereitgestellt werden. Soll nun ein neuer Spannungswandler konzipiert werden, so können die Anforderungen für diesen neuen Spannungswandler mit den in der Speichereinrichtung 20 gespeicherten Betriebsparametern von bereits bestehenden Spannungswandlern abgeglichen werden. Auf diese Weise kann abgeschätzt werden, mit welcher Wahrscheinlichkeit eine Fehlfunktion in Halbleiterschaltern des neu zu konzipierenden Spannungswandlers auftreten wird. Entsprechend kann eine geeignete Anzahl von redundanten Schaltelementen ermittelt werden, die in dem neu zu konzipierenden Spannungswandler vorzusehen ist. Durch die automatische Erfassung der Betriebsparameter in bestehenden Spannungswandlern und den Abgleich der erfassten Betriebsparameter mit den Anforderungen für einen neu zu konzipierenden Spannungswandler kann somit eine optimale Auslegung der Konfiguration für den neu zu konzipierenden Spannungswandler erreicht werden.

Fig. 4 zeigt eine schematische Darstellung eines Ablaufdiagramms, wie es einem Verfahren zur Konfiguration eines technischen Systems zugrunde liegt. In Schritt S1 werden vorbestimmte Betriebsparameter einer Anzahl von bestehenden technischen Systemen 100-i erfasst. In Schritt S2 werden die erfassten Betriebsparameter in einer zentralen Speichereinrichtung 20 gespeichert. In Schritt S3 werden die vorgegebenen Spezifikationen für ein neu zu konzipierendes technisches System empfangen und in Schritt S4 die gespeicherten Betriebsparameter aus der Speichereinrichtung 20 ausgelesen. Daraufhin kann in Schritt S5 eine Konfiguration für ein neu zu konzipierendes technisches System ermittelt werden. Die Ermittlung kann unter Verwendung der vorgegebenen Spezifikationen und der gespeicherten Betriebsparameter erfolgen.

Insbesondere kann das Verfahren einen Schritt zum Berechnen einer Ausfallwahrscheinlichkeit für vorgebestimmte Betriebsmittel des neu zu konzipierenden technischen Systems umfassen. Die Ausfallwahrscheinlichkeit kann unter Verwendung der gespeicherten Betriebsparameter berechnet werden.

Zusammenfassend betrifft die vorliegende Erfindung eine optimierte und automatisierte Konzeption von individuell zu planenden technischen Anlagen. Hierzu werden zunächst bei bereits bestehenden technischen Anlagen Betriebsparameter erfasst und zentral gespeichert. Soll eine neue technische Anlage geplant werden, so können die Spezifikationen für die neue Anlage mit den zuvor erfassten Betriebsparametern abgeglichen werden, um auf effiziente Weise eine optimale Konfiguration der neuen technischen Anlage zu generieren.

## Patentansprüche

1. Anordnung zur Konfiguration eines technischen Systems, mit:
einer Anzahl von Erfassungseinrichtungen (10-i), wobei jede Erfassungseinrichtung (10-i) dazu ausgelegt ist, vorbestimmte Betriebsparameter jeweils eines bestehenden technischen Systems (100-i) zu erfassen;
einer Speichereinrichtung (20), die dazu ausgelegt ist, die von der Anzahl von Erfassungseinrichtungen (10-i) erfassten Betriebsparameter zu empfangen und zu speichern; und
einer Konfigurationseinrichtung (30), die dazu ausgelegt ist, vorgegebene Spezifikationen (31, 32) für ein neu zu konzipierendes technisches System zu empfangen, die in der Speichereinrichtung (20) gespeicherten Betriebsparameter auszulesen, und unter Verwendung der vorgegebenen Spezifikationen (31, 32) und der gespeicherten Betriebsparameter eine Konfiguration (33) für das neu zu konzipierende technische System zu ermitteln.

2. Anordnung nach Anspruch 1, wobei die Betriebsparameter eine minimale und/oder maximale Betriebstemperatur eines Betriebsmittels, ein Über- und/oder Unterschreiten eines Schwellwerts, einen Ausfall eines Betriebsmittel, insbesondere einen Zeitpunkt des Ausfalls des Betriebsmittels, eine Einschalt- und/oder Ausschaltzeitdauer eines Betriebsmittels, eine relative Belastung eines Betriebsmittels, einen Nutzungsgrad eines Betriebsmittels oder eine mechanische Beanspruchung eines Betriebsmittels umfassen.

3. Anordnung nach Anspruch 1 oder 2, wobei die Konfigurationseinrichtung (30) dazu ausgelegt ist, eine Dimensionierung einer Baugruppe des neu zu konzipierenden technischen Systems unter Verwendung einer maximalen Beanspruchung einer korrespondierenden Baugruppe eines bestehenden technischen Systems festzulegen, und
wobei die maximale Beanspruchung der korrespondierenden Baugruppe des bestehenden technischen Systems unter Verwendung der gespeicherten Betriebsparameter ermittelt wird.

4. Anordnung nach Anspruch 3, wobei die Konfigurationseinrichtung (30) dazu ausgelegt ist, eine zu erwartende Beanspruchung einer Baugruppe des neu zu konzipierenden technischen Systems unter Verwendung der in der Speichereinrichtung (20) gespeicherten Betriebsparameter zu bestimmen.

5. Anordnung nach einem der Ansprüche 1 bis 4, wobei die Konfigurationseinrichtung (30) dazu ausgelegt ist, die Erfassung der vorbestimmten Betriebsparameter der bestehenden technischen Systeme (100-i) anzupassen.

6. Anordnung nach Anspruch 5, wobei die Konfigurationseinrichtung (30) dazu ausgelegt ist, die Erfassung der vorbestimmten Betriebsparameter in den bestehenden technischen Systemen (100-i) unter Verwendung der vorgegebenen Spezifikationen für ein neu zu konzipierendes technisches System anzupassen.

7. Anordnung nach einem der Ansprüche 1 bis 6, wobei die Erfassungseinrichtungen (10-i) einen Speicher und eine Verarbeitungseinrichtung (12) umfassen,
wobei der Speicher dazu ausgelegt ist, die erfassten Betriebsparameter zu speichern, und
wobei die Verarbeitungseinrichtung (12) dazu ausgelegt ist, die gespeicherten Betriebsparameter zu komprimieren und die komprimierten Betriebsparameter an die Speichereinrichtung (20) zu übertragen.

8. Anordnung nach einem der Ansprüche 1 bis 7, wobei Erfassungseinrichtung (10-i) dazu ausgelegt ist, die vorbestimmten Betriebsparameter kontinuierlich oder in vorbestimmten Zeitintervallen an die Speichereinrichtung (20) zu übertragen.

9. Anordnung nach einem der Ansprüche 1 bis 7, wobei Erfassungseinrichtung (10-i) dazu ausgelegt ist, die vorbestimmten Betriebsparameter zu übertragen, wenn ein vorbestimmtes Ereignis in dem jeweiligen bestehenden technischen System (100-i) detektiert worden ist.

10. Anordnung nach einem der Ansprüche 1 bis 9, wobei die Speichereinrichtung (20) eine Klassifizierungseinrichtung (22) umfasst, die dazu ausgelegt ist, die von der Erfassungseinrichtung (10-i) bereitgestellten Daten basierend auf vorbestimmten Kriterien zu klassifizieren und/oder zu gruppieren.

11. Anordnung nach Anspruch 10, wobei die vorbestimmten Kriterien eine räumliche Position des jeweiligen bestehenden technischen Systems (100-i), eine Häufigkeit von Fehlern, eine Fehlerursache, eine Auslastung des jeweiligen bestehenden technischen Systems (100-i) und/oder einen Betriebszustand des jeweiligen bestehenden technischen Systems (100-i) umfassen.

12. Anordnung nach einem der Ansprüche 1 bis 11, wobei die Konfigurationseinrichtung (30) ein neuronales Netz (35) umfasst, das dazu ausgelegt ist, die Konfiguration des neu zu konzipierenden technischen Systems ermitteln, und
wobei die Konfigurationseinrichtung dazu ausgelegt ist, das neuronale Netz (35) unter Verwendung der in der Speichereinrichtung (20) gespeicherten Betriebsparameter zu trainieren.

13. Verfahren zur Konfiguration eines technischen Systems, mit den Schritten:
Erfassen (S1) vorbestimmter Betriebsparameter eine Anzahl von bestehenden technischen Systemen (100-i);
Speichern (S2) der erfassten Betriebsparameter in einer zentralen Speichereinrichtung (20);
Empfangen (S3) vorgegebener Spezifikationen (310 32) für ein neu zu konzipierendes technisches System;
Auslesen (S4) der in der Speichereinrichtung gespeicherten Betriebsparameter; und
Ermitteln (S5) einer Konfiguration (35) für ein neu zu konzipierendes technisches System unter Verwendung der vorgegebenen Spezifikationen (31, 32) und der gespeicherten Betriebsparameter.

14. Verfahren nach Anspruch 13, wobei der Schritt (S5) zum Ermitteln der Konfiguration eine Berechnung einer Ausfallswahrscheinlichkeit für ein vorbestimmtes Betriebsmittel des neu zu konzipierenden technischen Systems umfasst, und wobei die Ausfallwahrscheinlichkeit unter Verwendung der gespeicherten Betriebsparameter berechnet wird.
